# EUROPEAN PATENT SPECIFICATION

(11) **EP 3 521 014 B1**
(45) Date of publication and mention of the grant of the patent: **09.12.2020**
(21) Application number: 19154525.0
(22) Date of filing: 30.01.2019
(51) Int. Cl.: B32B 15/01, C25D 5/10, C25D 5/48, C25D 5/50, C23C 28/02, G01R 31/26, H01R 13/03, C25D 11/36, C22C 5/00, C22C 5/02, C22C 5/04, C22C 5/06, C23C 30/00, H01B 1/02, C25D 3/12, C25D 3/30, C25D 3/46, C25D 3/54, C25D 3/56, C25D 3/64

(54) **SURFACE TREATED METAL MATERIAL FOR BURN-IN TEST SOCKET, CONNECTOR FOR BURN-IN TEST SOCKET AND BURN-IN TEST SOCKET USING THE SAME**
OBERFLÄCHENBEHANDELTES METALLMATERIAL FÜR EINBRENNPRÜFUNGSSOCKEL, VERBINDER FÜR EINBRENNPRÜFUNGSSOCKEL UND EINBRENNPRÜFUNGSSOCKEL MIT VERWENDUNG DAVON
MATÉRIAU MÉTALLIQUE TRAITÉ EN SURFACE POUR UNE PRISE DE TEST D'ÉCHAUFFEMENT, CONNECTEUR DE PRISE DE TEST D'ÉCHAUFFEMENT ET PRISE DE TEST D'ÉCHAUFFEMENT L'UTILISANT

(30) Priority: 01.02.2018 JP 2018016777
(43) Date of publication of application: 07.08.2019
(73) Proprietor: JX Nippon Mining & Metals Corporation, Tokyo 100-8164 (JP)
(72) Inventor: ENDO, Satoru, Hitachi-shi, Ibaraki 317-0056 (JP)
(74) Representative: Hooiveld, Arjen Jan Winfried

(56) References cited:
- EP-A1- 2 759 622
- EP-A1- 2 829 637
- EP-A1- 2 868 772
- EP-A1- 2 868 773
- EP-A1- 2 905 356
- JP-A- 2015 206 094
- JP-B2- 2 959 872

## Description

The present invention relates to a surface treated metal material for burn-in test socket, a connector for burn-in test socket and a burn-in test socket using the same.

In a quality test conducted to remove in advance initial failure of semiconductor devices and so on, a burn-in test is conducted to reduce testing time by heating a specimen with temperature and voltage controls to accelerate degradation of the specimen.

A burn-in test socket is used for the burn-in test (Patent Literature 1), and comprises a connector for burn-in test socket in an electrical contact portion with the specimen.

Japanese Patent Application Laid-Open Publication No. 2010-109386 is cited.

JP 2015 206094 A describes a metallic material for an electronic component; a connector terminal using the same, a connector, and an electronic component. The material has a lower layer of Ni, an intermediate layer of Ni-Sn or Ni-In alloy, and an upper layer of Ag-Sn, Ag-In, Pd-Sn or Pd-In alloys.

A contact resistance value of the contact used for burn-in test socket can increase when a heat retention test at a predetermined temperature and for a predetermined time is conducted by contacted with a metal material of the specimen. When the contact resistance value increases, it is difficult to conduct burn-in test accurately because there is a risk of erroneously determining that the resistance value of IC being tested rises.

The present invention has been made to solve the above problems, and provides a surface treated metal material for burn-in test socket wherein contact resistance between the contact of the socket and other metal materials being inserted is excellently suppressed when used for the contact for burn-in test socket.

The present inventors made a diligent study, and consequently have discovered that a surface treated metal material for burn-in test socket to solve the problem can be prepared by disposing a lower layer, an intermediate layer and an upper layer in this order on a base material, using predetermined metals for the lower layer, the intermediate layer and the upper layer, respectively, and assigning predetermined thickness values and predetermined compositions to the lower, intermediate and upper layers, respectively.

An aspect of the present invention perfected on the basis of the above-described discovery is a surface treated metal material for burn-in test socket as defined in appended claim 1.

The present invention is, in another aspect thereof, a connector for burn-in test socket comprising the surface treated metal material of the present invention.

The present invention is, in yet another aspect thereof, a burn-in test socket comprising the connector of the present invention.

According to the present invention, it is possible to provide a surface treated metal material for burn-in test socket wherein contact resistance between the contact of the socket and other metal materials being inserted is excellently suppressed when used for the contact for burn-in test socket.

### [Brief Description of Drawings]

[Figure 1] Figure 1 is a schematic diagram illustrating the structure of a surface treated metal material according to an embodiment of the present invention.
[Figure 2] Figure 2 is an observed picture of sample showing a state of contact resistance evaluation.

### [Description of Embodiments]

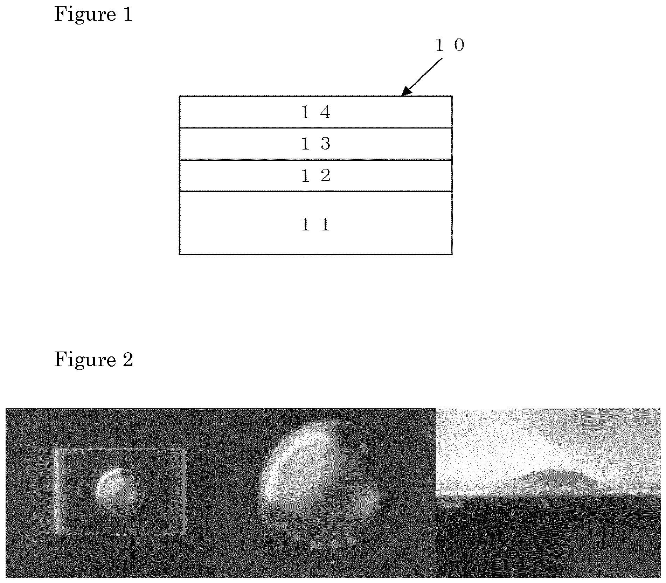

Hereinafter, the surface treated metal material for burn-in test socket according to the embodiments of the present invention are described. As shown in Figure 1, the surface treated metal material 10 for burn-in test socket according to an embodiment includes a base material 11, an lower layer 12 formed on the base material 11, an intermediate layer 13 formed on the lower layer 12 and an upper layer 14 formed on the intermediate layer 13.

### <Structure of surface treated metal material for burn-in test socket>

### (Base material)

Usable examples of the base material 11 include, without being particularly limited to, metal base materials such as copper and copper alloys, Fe-based materials, stainless steel, titanium and titanium alloys and aluminum and aluminum alloys.

### (Upper layer)

The upper layer 14 is constituted with an alloy composed of Ag-Sn. Sn is an oxidizable metal, but is characterized by being relatively soft among metals. Accordingly, even when an oxide film is formed on the surface of Sn, for example at the time of joining together terminals by using the surface treated metal material as a contact material, the oxide film is easily scraped to result in contact between metals, and hence a low contact resistance is obtained.

Sn is excellent in the gas corrosion resistance against the gases such as chlorine gas, sulfurous acid gas and hydrogen sulfide gas; for example, when Ag poor in gas corrosion resistance is used for the upper layer 14, Ni poor in gas corrosion resistance is used for the lower layer 12, and copper or a copper alloy poor in gas corrosion resistance is used for the base material 11, Sn has an effect to improve the gas corrosion resistance of the surface treated metal material. Sn is preferable over In because In is severely regulated on the basis of the technical guidelines for the prevention of health impairment prescribed by the Ordinance of Ministry of Health, Labour and Welfare.

Ag, and, for example, Au, Pt, Pd, Ru, Rh, Os and Ir, are characterized by being relatively heat-resistant among metals. Accordingly, Ag suppresses the diffusion of the composition of the base material 11, the lower layer 12 and the intermediate layer 13 toward the side of the upper layer 14 to improve the heat resistance. The Ag also forms compounds with Sn in the upper layer 14 to suppress the formation of the oxide film of Sn, so as to improve the solder wettability. Among Ag, Au, Pt, Pd, Ru, Rh, Os and Ir, Ag is more desirable from the viewpoint of electrical conductivity. Ag is high in electrical conductivity. For example, when Ag is used for high-frequency wave signals, impedance resistance is made low due to the skin effect

The thickness of the upper layer 14 is required to be 0.02 µm or more and less than 1.00 µm. When the thickness of the upper layer 14 is less than 0.02 µm, the composition of the base material 11 or the lower layer 12 tends to diffuse to the side of the upper layer 14 and the heat resistance or the solder wettability is degraded. Additionally, the upper layer is worn by fine sliding, and the lower layer 12 high in contact resistance tends to be exposed, and hence the fine sliding wear resistance is poor and the contact resistance tends to be increased by fine sliding. Moreover, the lower layer 12 poor in gas corrosion resistance tends to be exposed, and hence the gas corrosion resistance is poor, and the exterior appearance is discoloured when a gas corrosion test is performed. On the other hand, when the thickness of the upper layer 14 is 1.00 µm or more, the thin film lubrication effect due to the hard base material 11 or the hard lower layer 12 is degraded and the adhesive wear is increased. The mechanical durability is also degraded and scraping of plating tends to occur.

The upper layer 14 preferably includes the Sn in a content of 10 to 50 at%. When the content of the Sn is less than 10 at%, for example, the gas corrosion resistance is poor, and the exterior appearance can be discoloured when a gas corrosion test is performed. On the other hand, when the content of the Sn exceeds 50 at%, the proportion of the Sn in the upper layer 14 is large and the adhesive wear can be increased.

(Intermediate layer) Between the lower layer 12 and the upper layer 14, the intermediate layer 13 constituted with Ni and Sn is required to be formed in a thickness of 0.01 µm or more and less than 0.40 µm. Sn is excellent in the gas corrosion resistance against the gases such as chlorine gas, sulfurous acid gas and hydrogen sulfide gas, for example, when Ni poor in gas corrosion resistance is used for the lower layer 12 and copper and copper alloy poor in gas corrosion resistance is used for the base material 11, Sn has a function to improve the gas corrosion resistance of the surface treated metal material. Ni provides a harder coating as compared with Sn, accordingly make the adhesive wear hardly occur, prevent the diffusion of the constituent metal(s) of the base material 11 into the upper layer 14, and thus improve the durability in such a way that the degradation of the heat resistance or the degradation of the solder wettability is suppressed.

When the thickness of the intermediate layer 13 is less than 0.01 µm, the coating becomes soft and the adhesive wear is increased. On the other hand, the thickness of the intermediate layer 13 is 0.40 µm or more, the bending processability is degraded, the mechanical durability is also degraded, and scraping of plating can occur.

Sn is preferable over In because In is severely regulated on the basis of the technical guidelines for the prevention of health impairment prescribed by the Ordinance of Ministry of Health, Labour and Welfare. Ni is preferable among Ni, Cr, Mn, Fe, Co and Cu. This is because Ni is hard, and accordingly the adhesive wear hardly occurs and sufficient bending processability is obtained. In the intermediate layer 13, the content of the Ni is preferably 35 at% or more. When the content of Sn is 35 at% or more, the coating becomes hard and the adhesive wear can be decreased.

(Lower layer) Between the base material 11 and the intermediate layer 13, it is necessary to form the lower layer 12 constituted with Ni or Ni-Co. By forming the lower layer 12 with Ni or Ni-Co, the hard lower layer 12 is formed, hence the thin film lubrication effect is improved and the adhesive wear is decreased, and the lower layer 12 prevents the diffusion of the constituent metal(s) of the base material 11 into the upper layer 14 and improves, for example, the heat resistance or the solder wettability.

The thickness of the lower layer 12 is required to be 0.05 µm or more. When the thickness of the lower layer 12 is less than 0.05 µm, the thin film lubrication effect due to the hard lower layer is degraded and the adhesive wear is increased. The diffusion of the constituent metal(s) of the base material 11 into the upper layer 14 is facilitated, and the heat resistance or the solder wettability is degraded. On the other hand, the thickness of the lower layer 12 is required to be less than 5.00 µm. When the thickness is 5.00 µm or more, bending processability is poor.

### < Properties of surface treated metal material for burn-in test socket>

A contact resistance value of the surface treated metal material for burn-in test socket of the present invention is 2.0 mΩ or less when held for 200 hours at 180°C with contacting the surface treated metal material with other metal material(s) from a side of the upper layer. Accordingly, the surface treated metal material for burn-in test socket of the present invention, when used in the connector for burn-in test socket, can excellently suppress increase of contact resistance even when heated and held under predetermined conditions in contact with another metal material. The contact resistance value is preferably 1.8 mΩ or less, more preferably 1.6 mΩ or less.

Furthermore, a diffusion depth of a coating metal element of the other metal material(s) in the surface treated metal material for burn-in test socket of the present invention, when held for 200 hours at 180°C with contacting the surface treated metal material at contact load of 2.4 N with other metal material(s) from the side of the upper layer, is 0.5 µm or less from the surface of the surface treated metal material. Accordingly, the surface treated metal material for burn-in test socket of the present invention, when used in the connector for burn-in test socket, can excellently suppress increase of contact resistance even when heated, held and applied a load under predetermined conditions in contact with another metal material. The diffusion depth of the coating metal element of the other metal material(s) in the surface treated metal material is preferably 0.4 µm or less from the surface of the surface treated metal material, and more preferably 0.3 µm or less from the surface of the surface treated metal material.

### <Applications of Surface treated metal material for burn-in test socket>

The surface treated metal material for burn-in test socket of the present invention can be used as a connector for burn-in test socket. A burn-in test socket can be produced by using the connector manufactured by using the surface treated metal material for burn-in test socket of the present invention. In the burn-in test socket comprising the connector manufactured by using the surface treated metal material for burn-in test socket of the present invention, a contact resistance between a contact of the burn-in test socket and other metal material(s) can be excellently suppressed.

### <Method for Producing Surface treated metal material for burn-in test socket>

As the method for producing the surface treated metal material for burn-in test socket of the present invention, for example, either a wet plating (electroplating or electroless plating) or a dry plating (sputtering or ion plating) can be used.

### [Examples]

Hereinafter, both Examples of the present invention and Comparative Examples are presented, these Examples and Comparative Examples are provided for better understanding of the present invention, and are not intended to limit the present invention.

As materials, the following plate material and dome material was prepared.

As Examples 1 to 16, Comparative Examples 1 to 5, 8, 9, and Reference Examples 6, 7, under the following conditions, the surface treatment was performed in the sequence of electrolytic first plating, second plating, and/or third plating, and phosphate ester type liquid treatment and heat treatment on the surface of the base material (dome material). Table 1 shows plating type, plating thickness at manufacturing, conditions of phosphate ester type liquid treatment and heat treatment in Examples, Comparative Examples, Reference Examples.

### (Base material)

(1) "Plate material" thickness: 0.25 mm, width: 8 mm, component: brass, Sn plating of the thickness of 1.0 µm
(2) "Dome material" thickness: 0.2 mm, width: 12 mm, component: brass

### (First Plating Conditions)

### [Ni plating]

Surface treatment method: Electroplating
Plating solution: Ni sulfamate (150 g/L) + boric acid (30 g/L)
Plating temperature: 55 °C
Electric current density: 0.5 to 4 A/dm²

### [Ni-Co plating]

Surface treatment method: Electroplating
Plating solution: Ni sulfamate (60 g/L) + cobalt sulfate (60 g/L) + boric acid (30 g/L)
Plating temperature: 55 °C
Electric current density: 0.5 to 4 A/dm²

### (Second Plating Conditions)

### [Ag plating]

Surface treatment method: Electroplating
Plating solution: Ag cyanide (10 g/L) + potassium cyanide (30 g/L)
Plating temperature: 40 °C
Electric current density: 0.2 to 4 A/dm²

### [Ag-Sn plating]

Surface treatment method: Electroplating
Plating solution: Ag methanesulfonate (1 g/L) + Sn methanesulfonate (50 g/L) + methanesulfonic acid (180 g/L)
Plating temperature: 25 °C
Electric current density: 3 to 5 A/dm²

### [Sn plating]

Surface treatment method: Electroplating
Plating solution: Sn methanesulfonate (50 g/L) + methanesulfonic acid (200 g/L)
Plating temperature: 30 °C
Electric current density: 5 to 7 A/dm²

### [In plating]

Surface treatment method: Electroplating
Plating solution: In methanesulfonate (50 g/L) + methanesulfonic acid (200 g/L)
Plating temperature: 40 °C
Electric current density: 5 to 7 A/dm²

### (Third Plating Conditions)

### [Sn plating]

Surface treatment method: Electroplating
Plating solution: Sn methanesulfonate (50 g/L) + methanesulfonic acid (200 g/L)
Plating temperature: 30 °C
Electric current density: 5 to 7 A/dm²

### [Sn-Ag plating]

Surface treatment method: Electroplating
Plating solution: Ag methanesulfonate (1 g/L) + Sn methanesulfonate (50 g/L) + methanesulfonic acid (180 g/L)
Plating temperature: 25 °C
Electric current density: 3 to 5 A/dm²

### (Phosphate ester type liquid treatment)

After forming first plating, second plating and third plating, phosphate ester type liquid treatment was conducted on the surface of the plating, under the following conditions by using the following phosphate ester species (A1, A2) and cyclic organic compound species (B1, B2), as shown Table 1. Deposition amounts of P and N on the surface of the plating after phosphate ester type liquid treatment are shown in Table 1.

### [Phosphate ester species: A1]

Lauryl acid phosphate monoester (phosphoric acid monolauryl ester)
[Phosphate ester species: A2]
   Lauryl acid phosphate diester (phosphoric acid dilauryl ester)
[Cyclic organic compound species: B1]
   Benzotriazole
[Cyclic organic compound species: B2]
   Sodium salt of mercaptobenzothiazole

The surface treatment can be conducted by coating phosphate ester type liquid on the surface of the manufactured upper layer 14. An example of the coating method can be spray coating, flow coating, dip coating, roll coating and so on. The dip coating and the spray coating are preferable from the viewpoint of productivity. On the other hand, as the other example, the treatment method can be conducted by immersing the metal material after manufacturing the upper layer 14 in the phosphate ester type liquid to conduct electrolysis by using the metal material as anode. The metal material treated with the method has advantages that contact resistance under high temperature environment is harder to rise.

The surface treatment by phosphate ester type liquid, as explained so far, can be conducted after the upper layer 14 is manufactured or after reflow processing to the manufactured upper layer 14. There is no time restriction for the surface treatment, but it is preferable to be conducted in a series of steps from an industrial point of view.

### (Heat treatment)

Finally, the heat treatment was performed, under the atmosphere and the heating time shown in Table 1, by placing the sample on a hot plate, and verifying that the surface of the hot plate reached the temperature shown in Table 1.

### (Measurement of thickness of lower layer)

The thickness of the lower layer was measured with the X-ray fluorescent analysis thickness meter (SEA5100, collimator: 0.1 mmΦ, manufactured by Seiko Instruments Inc.).

In the measurement of the thickness of the lower layer, the evaluations were performed for arbitrary 10 points and the resulting values were averaged.

### (Determination of structures [compositions] and measurement of thicknesses of surface layer, upper layer and intermediate layer)

The determination of the structures and the measurement of the thicknesses of the upper layer and the intermediate layer of each of the obtained samples were performed by the line analysis based on the STEM (scanning transmission electron microscope) analysis. The thickness corresponds to the distance determined from the line analysis (or area analysis). As the STEM apparatus, the JEM-2100F manufactured by JEOL Ltd. was used. The acceleration voltage of this apparatus is 200 kV.

In the determination of the structures and measurement of the thicknesses of the upper layer and the intermediate layer of each of the obtained samples, the evaluations were performed for arbitrary 10 points and the resulting values were averaged. The thickness of the surface layer was measured in the same way as the upper layer and the intermediate layer.

### (Evaluations)

A contact resistance evaluation of each sample was conducted under the following conditions. Figure 2 shows an observed picture of sample showing a state of contact resistance evaluation. In Figure 2, a left figure shows overall plane observation picture of dome material, a central figure shows enlarged plane observation picture of dome material and a right figure shows side plane observation picture of dome material.

As shown in Figure 2, the manufactured plate material was inserted into the dome material to contact with. Next, in maintaining the sate of contacting the plate material with the dome material, they were held for 200 hours at 180 °C. Then, the contact resistance was measured with the contact simulator model CRS-113-Au manufactured by Yamasaki-seiki Co., Ltd., under the condition of the contact load of 1N, 2N, 3N and 5N, on the basis of the four-terminal method.

In addition, the manufactured plate material was inserted into the dome material to contact with at contact load of 2.4 N. Next, in maintaining the sate of contacting the plate material with the dome material, they were held for 200 hours at 180 °C. Then, the depth of diffusion to the dome material, of a coating metal element of a surface of the plate material, from a surface of the dome material, was measured.

Composition, evaluation conditions and results of each sample are shown in Tables 1 and 2. "Thickness" in Table 1 indicates the thickness of first plating, second plating and third plating to produce. "Thickness" in Table 2 indicates the thickness of alloyed plating.

**[Table 1]**

| | First plating | | Second plating | | Third plating | Phosphate ester type liquid treatment condition | | | | | Heat treatment | | |
|---|---|---|---|---|---|---|---|---|---|---|---|---|---|
| | | | | | | (Dipping treatment in non-underlined section. Anodic electrolysis at 2V for 5 seconds in underlined section: Example 16) | | | | | | | |
| | Plating species | Thickness [*µ*m] | Plating species | Thickness [*µ*m] | Plating species | Thickness [*µ*m] | Phosphate ester species | Cyclic organic compound species | Deposition amounts of P mol/cm2 | Deposition amounts of N mol/cm2 | Temperature [°C] | Time [sec] | Atmosphere |
| Example 1 | Ni | 1.0 | Ag | 0.2 | Sn | 0.15 | A1 | B1 | 6×10⁻⁶ | 2×10⁻⁶ | 650 | 10 | N₂ gas |
| Example 2 | Ni-Co | 1.0 | Ag | 0.2 | Sn | 0.15 | A1 | B1 | 7×10⁻⁶ | 2×10⁻⁶ | 650 | 10 | N₂ gas |
| Example 3 | Ni | 1.0 | Ag-Sn | 0.2 | Sn | 0.15 | A1 | B1 | 7×10⁻⁶ | 2×10⁻⁶ | 650 | 10 | N₂ gas |
| Example 4 | Ni | 1.0 | Ag | 0.2 | Sn | 0.15 | A1 | B1 | 8×10⁻⁶ | 3×10⁻⁶ | 650 | 12 | N₂ gas |
| Example 5 | Ni | 1.0 | Ag | 0.2 | Sn-Ag | 0.15 | A1 | B1 | 7×10⁻⁶ | 2×10⁻⁶ | 650 | 10 | N₂ gas |
| Example 6 | Ni | 1.0 | Ag | 0.2 | Sn | 0.15 | A1 | B1 | 8×10⁻⁶ | 2×10⁻⁶ | 670 | 10 | N₂ gas |
| Example 7 | Ni | 1.0 | Ag | 0.2 | Sn | 0.15 | A2 | B1 | 7×10⁻⁶ | 2×10⁻⁶ | 650 | 10 | N₂ gas |
| Example 8 | Ni | 1.0 | Ag | 0.2 | Sn | 0.15 | A1 | B2 | 7×10⁻⁶ | 3×10⁻⁶ | 650 | 10 | N₂ gas |
| Example 9 | Ni | 1.0 | Ag | 0.2 | Sn | 0.15 | A1 | B1 | 7×10⁻⁶ | 2×10⁻⁶ | 630 | 15 | N₂ gas |
| Example 10 | Ni | 1.0 | Ag | 0.2 | Sn | 0.15 | A1 | B1 | 7×10⁻⁶ | 2×10⁻⁶ | 650 | 10 | N₂ gas |
| Example 11 | Ni | 1.0 | Ag | 0.1 | Sn | 0.1 | A1 | B1 | 7×10⁻⁶ | 2×10⁻⁶ | 650 | 10 | N₂ gas |
| Example 12 | Ni | 1.0 | Ag | 0.2 | Sn | 0.2 | A1 | B1 | 7×10⁻⁶ | 2×10⁻⁶ | 650 | 10 | N₂ gas |
| Example 13 | Ni | 1.0 | Ag | 0.25 | Sn | 0.15 | A1 | B1 | 7×10⁻⁶ | 2×10⁻⁶ | 650 | 10 | N₂ gas |
| Example 14 | Ni | 1.0 | Ag | 0.2 | Sn | 0.25 | A1 | B1 | 7×10⁻⁶ | 2×10⁻⁶ | 650 | 10 | N₂ gas |
| Example 15 | Ni | 0.5 | Ag | 0.2 | Sn | 0.15 | A1 | B1 | 7×10⁻⁶ | 2×10⁻⁶ | 650 | 10 | N₂ gas |
| Example 16 | Ni | 1.5 | Ag | 0.2 | Sn | 0.15 | A1 | B1 | 7×10⁻⁶ | 2×10⁻⁶ | 650 | 10 | N₂ gas |
| Comparative Example 1 | Ni | 1.0 | Ag | 0.2 | Sn | 0.35 | A1 | B1 | 7×10⁻⁶ | 2×10⁻⁶ | 650 | 10 | N₂ gas |
| Comparative Example 2 | Ni | 1.0 | Ag | 0.2 | Sn | 0.15 | A1 | B1 | 7×10⁻⁶ | 2×10⁻⁶ | 650 | 5 | N₂ gas |
| Comparative Example 3 | Ni | 1.0 | Ag | 0.2 | Sn | 0.15 | A1 | B1 | 7×10⁻⁶ | 2×10⁻⁶ | 600 | 10 | N₂ gas |
| Comparative Example 4 | Ni | 1.0 | Ag | 0.2 | Sn | 0.15 | | | | | 650 | 10 | N₂ gas |
| Comparative Example 5 | Ni | 1.0 | Sn | 1.0 | | | | | | | | | |
| Reference Example 6 | Ni | 1.0 | Ag | 2.0 | | | | | | | | | |
| Reference Example 7 | Ni | 1.0 | Au | 0.4 | | | | | | | | | |
| Comparative Example 8 | Ni | 1.0 | Ag-Sn | 0.4 | | | | | | | | | |
| Comparative Example 9 | Ni | 1.0 | In | 1.0 | | | | | | | | | |

**[Table 2]**

| | Lower layer | | Intermediate layer | | Upper layer | | Surface layer | | Contact resistance (after held for 200hours at 180°C) | | Diffusion depth of metal element from the surface of the surface treated metal material |
|---|---|---|---|---|---|---|---|---|---|---|---|
| | Composition | Thickness [*µ*m] | Composition | Thickness [*µ*m] | Composition | Thickness [*µ* m] | Composition | Thickness [*µ*m] | before heating [mΩ] | after heating [mΩ] | [*µ*m] |
| Example 1 | Ni | 1.0 | Ni-Sn | 0.14 | Ag-Sn | 0.27 | - | - | 1.70 | 1.54 | 0.24 |
| Example 2 | Ni-Co | 1.0 | Ni-Sn | 0.12 | Ag-Sn | 0.22 | - | - | 1.74 | 1.71 | 0.28 |
| Example 3 | Ni | 1.0 | Ni-Sn | 0.17 | Ag-Sn | 0.25 | - | - | 1.83 | 1.78 | 0.28 |
| Example 4 | Ni | 1.0 | Ni-Sn | 0.15 | Ag-Sn | 0.25 | - | - | 1.77 | 1.63 | 0.25 |
| Example 5 | Ni | 1.0 | Ni-Sn | 0.10 | Ag-Sn | 0.31 | - | - | 1.74 | 1.59 | 0.24 |
| Example 6 | Ni | 1.0 | Ni-Sn | 0.14 | Ag-Sn | 0.22 | - | - | 1.80 | 1.62 | 0.26 |
| Example 7 | Ni | 1.0 | Ni-Sn | 0.13 | Ag-Sn | 0.23 | - | - | 1.75 | 1.55 | 0.23 |
| Example 8 | Ni | 1.0 | Ni-Sn | 0.15 | Ag-Sn | 0.26 | - | - | 1.70 | 1.53 | 0.21 |
| Example 9 | Ni | 1.0 | Ni-Sn | 0.13 | Ag-Sn | 0.27 | - | - | 1.68 | 1.52 | 0.23 |
| Example 10 | Ni | 1.0 | Ni-Sn | 0.14 | Ag-Sn | 0.28 | - | - | 1.85 | 1.48 | 0.21 |
| Example 11 | Ni | 1.0 | Ni-Sn | 0.07 | Ag-Sn | 0.14 | - | - | 1.89 | 1.79 | 0.30 |
| Example 12 | Ni | 1.0 | Ni-Sn | 0.21 | Ag-Sn | 0.28 | - | - | 1.77 | 1.60 | 0.27 |
| Example 13 | Ni | 1.0 | Ni-Sn | 0.14 | Ag-Sn | 0.32 | - | - | 1.70 | 1.51 | 0.24 |
| Example 14 | Ni | 1.0 | Ni-Sn | 0.18 | Ag-Sn | 0.23 | - | - | 1.81 | 1.67 | 0.29 |
| Example 15 | Ni | 0.5 | Ni-Sn | 0.12 | Ag-Sn | 0.27 | - | - | 1.73 | 1.54 | 0.24 |
| Example 16 | Ni | 1.5 | Ni-Sn | 0.17 | Ag-Sn | 0.26 | - | - | 1.76 | 1.55 | 0.25 |
| Comparative Example 1 | Ni | 1.0 | Ni-Sn | 0.25 | Ag-Sn | 0.24 | Sn | 0.04 | 2.11 | 3.27 | - |
| Comparative Example 2 | Ni | 1.0 | Ni-Sn | 0.06 | Ag-Sn | 0.19 | Sn | 0.08 | 3.36 | 6.78 | - |
| Comparative Example 3 | Ni | 1.0 | Ni-Sn | 0.10 | Ag-Sn | 0.21 | Sn | 0.05 | 2.84 | 4.21 | - |
| Comparative Example 4 | Ni | 1.0 | Ni-Sn | 0.15 | Ag-Sn | 0.27 | - | - | 1.42 | 2.12 | 0.43 |
| Comparative Example 5 | Ni | 1.0 | | | Sn | 1.0 | - | - | 4.35 | 5.27 | - |
| Reference Example 6 | Ni | 1.0 | | | Ag | 2.0 | - | - | 1.32 | 1.31 | 1.14 |
| Reference Example 7 | Ni | 1.0 | | | Au | 0.4 | - | - | 1.53 | 1.95 | 1.21 |
| Comparative Example 8 | Ni | 1.0 | | | Ag-Sn | 0.4 | - | - | 5.87 | 2.41 | 0.62 |
| Comparative Example 9 | Ni | 1.0 | | | In | 1.0 | - | - | 2.88 | 64.60 | 1.42 |

In each of Examples 1 to 16, the contact resistance value was 2.0 mΩ or less by being held for 200 hours at 180°C with contacting the dome material with the plate material, and the contact resistance can be excellently suppressed.

In each of Examples 1 to 16, the contact resistance value is the same level as Reference Example 6 in which the upper layer constituted with Ag layer of the thickness of 2 µm including the change over time, and Reference Example 7 in which the upper layer constituted with Au layer of the thickness of 0.4 µm.

In each of Comparative Examples 1 to 5, 8, 9, the contact resistance value was over 2.0 mΩ by being held for 200 hours at 180°C with contacting the dome material with the plate material, and the contact resistance was poor.

In each of Comparative Examples 1 to 3, 5, pure Sn remains on the surface layer or the upper layer, the plate material with Sn plating has the same Sn on the surface. Therefore, the diffusion depth is not clear.

### [Reference Signs List]

- 10: surface treated metal material for burn-in test socket
- 11: base material
- 12: lower layer
- 13: intermediate layer
- 14: upper layer

## Claims

1. A surface treated metal material for burn-in test socket, comprising
a metal base material,
a lower layer being constituted with Ni or Ni-Co,
an intermediate layer formed on the lower layer, the intermediate layer being constituted with Ni-Sn, and
an upper layer formed on the intermediate layer, the upper layer being constituted with Ag-Sn, wherein
the thickness of the lower layer is 0.05 µm or more and less than 5.00 µm, the thickness of the intermediate layer is 0.01 µm or more and less than 0.40 µm, and the thickness of the upper layer is 0.02 µm or more and less than 1.00 µm **characterized in that** the surface treated metal material for burn-in test socket having a contact resistance value of 2.0 mΩ or less by being held for 200 hours at 180°C with contacting the surface treated metal material with other metal material(s) from a side of the upper layer, and
a diffusion depth of a coating metal element of the other metal material(s) in the surface treated metal material, by being held for 200 hours at 180°C with contacting the surface treated metal material at contact load of 2.4 N with other metal material(s) from a side of the upper layer, is 0.5 µm or less from a surface of the surface treated metal material.

2. A connector for burn-in test socket comprising the surface treated metal material according to claim 1.

3. A burn-in test socket comprising the connector according to claim 2.

## Patentansprüche

1. Oberflächenbehandeltes Metallmaterial für einen Einbrennprüfsockel, das aufweist
ein Metallbasismaterial,
eine untere Schicht, die aus Ni oder Ni-Co gebildet wird,
eine Zwischenschicht, die auf der unteren Schicht ausgebildet ist, wobei die Zwischenschicht mit Ni-Sn gebildet wird, und
eine obere Schicht, die auf der Zwischenschicht ausgebildet ist, wobei die obere Schicht mit Ag-Sn gebildet wird, wobei
die Dicke der unteren Schicht 0,05 µm oder mehr und kleiner als 5,00 µm ist, die Dicke der Zwischenschicht 0,01 µm oder mehr und kleiner als 0,40 µm ist, und die Dicke der oberen Schicht 0,02 µm oder mehr und kleiner als 1,00 µm ist,
**dadurch gekennzeichnet, dass**
das oberflächenbehandelte Metallmaterial für den Einbrennprüfsockel einen Kontaktwiderstandswert von 2,0 mΩ oder weniger hat, wobei das oberflächenbehandelte Metallmaterial mit anderen Metallmaterial(ien) von einer Seite der oberen Schicht für 200 Stunden bei 180 °C in Kontakt gehalten wird, und
eine Diffusionstiefe eines Beschichtungsmetallelements von dem/den anderen Metallmaterial(ien) im oberflächenbehandelte Material, indem es für 200 Stunden bei 180 °C mit dem oberflächenbehandelt Metallmaterial bei einer Kontaktlast von 2,4 N mit anderen Metallmaterial(ien) von einer Seite der oberen Schicht in Kontakt gehalten wird, 0,5 µm oder weniger von einer Fläche des oberflächenbehandelten Metallmaterials ist.

2. Verbinder für einen Einbrennprüfsockel, der das oberflächenbehandelte Metallmaterial nach Anspruch 1 aufweist.

3. Einbrennprüfsockel, der den Verbinder nach Anspruch 2 aufweist.

## Revendications

1. Matériau métallique traité en surface destiné à une prise de test d'endurance, comprenant
un matériau de base métallique,
une couche inférieure qui est constituée de Ni ou de Ni-Co,
une couche intermédiaire formée sur la couche inférieure, la couche intermédiaire étant constituée de Ni-Sn, et
une couche supérieure formée sur la couche intermédiaire, la couche supérieure étant constituée d'AG-Sn, dans lequel
l'épaisseur de la couche inférieure est supérieure ou égale à 0,05 µm et inférieure à 5,00 µm, l'épaisseur de la couche intermédiaire est supérieure ou égale à 0,01 µm et inférieure à 0,40 µm et l'épaisseur de la couche supérieure est supérieure ou égale à 0,02 µm et inférieure à 1,00 µm, **caractérisé en ce que**
le matériau métallique traité en surface, destiné à une prise de test d'endurance, présente une valeur de résistance de contact inférieure ou égale à 2,0 mΩ en étant maintenu pendant 200 heures à 180°C avec mise en contact du matériau métallique traité en surface avec un ou d'autres matériaux métalliques à partir d'un côté de la couche supérieure, et
une profondeur de diffusion d'un élément métallique de revêtement du ou des autres matériaux métalliques dans le matériau métallique traité en surface, en étant maintenu pendant 200 heures à 180°C avec mise en contact du matériau métallique traité en surface, sous une charge de contact de 2,4 N, avec un ou d'autres matériaux métalliques à partir d'un côté de la couche supérieure, est inférieure ou égale à 0,5 µm par rapport à une surface du matériau métallique traité en surface.

2. Connecteur destiné à une prise de test d'endurance, comportant le matériau métallique traité en surface selon la revendication 1.

3. Prise de test d'endurance comprenant le connecteur selon la revendication 2.
